Europäisches Patentamt

European Patent Office

Office européen des brevets

(11) Veröffentlichungsnummer: **0 131 185**
**A2**

# EUROPÄISCHE PATENTANMELDUNG

(21) Anmeldenummer: **84107125.1**

(22) Anmeldetag: **20.06.84**

(51) Int. Cl.⁴: **H 01 H 13/70**
**H 03 M 11/00**

(30) Priorität: **29.06.83 DE 3323463**

(43) Veröffentlichungstag der Anmeldung:
**16.01.85 Patentblatt 85/3**

(84) Benannte Vertragsstaaten:
**AT BE CH DE FR GB IT LI NL SE**

(71) Anmelder: **Siemens Aktiengesellschaft**
**Berlin und München Wittelsbacherplatz 2**
**D-8000 München 2(DE)**

(72) Erfinder: **Bernhard, Edel, Dipl.-Ing.**
**Silberblattsctr. 29**
**D-8000 München 70(DE)**

(54) **Tastenschalter.**

(57) Die Erfindung betrifft Tastaturen mit Tastenschaltern, die den Kreuzungspunkten von auf einer Verdrahtungsplatte befindlichen Zeilen- und Spaltenleitungen zugeordnet sind. Durch die Tastenschalter sind jeweils eine Zeilenleitung und eine Spaltenleitung verbindbar.

Zur eindeutigen Identifizierung von betätigten Tastenschaltern bei gleichzeitiger Betätigung mehrerer Tastenschalter werden in Serie zu den Schaltstrecken Entkopplungsdioden vorgesehen. Erfindungsgemäß werden die Entkopplungsdioden in die beweglichen Kontaktbrücken der Tastenschalter integriert, um lötfreie Verdrahtungsplatten zu erhalten.

FIG 1

SIEMENS AKTIENGESELLSCHAFT       Unser Zeichen
Berlin und München                83 P 1441 E

Tastenschalter

In Tastenfeldern mit einer Vielzahl von über Tasten betätigbaren Tastenschaltern muß jede gedrückte Taste eindeutig identifizierbar sein, auch wenn mehrere Tasten
gleichzeitig betätigt werden.

Häufig werden die Tastenschalter den Kreuzungspunkten von
Zeilen- und Spaltenleitungen einer Verdrahtungsplatte
mit matrixartig verlaufenden Leiterbahnen zugeordnet,
um die Zahl der nach außen führenden Verbindungen klein
zu halten.

Durch Drücken einer Taste wird jeweils eine Zeilenleitung
mit einer Spaltenleitung  verbunden. Um die Ausbildung
sogenannter Schleichpfade zu verhindern, die bei gleichzeitiger Betätigung von mehr als zwei Tasten entstehen
und zur fehlerhaften Identifizierung einer nicht gedrückten Taste führen können, werden in Serie zu den Schaltstrecken der Tastenschalter Entkopplungsdioden eingefügt
(Machine Design,  12.Nov.1981, S.68 bis 73).Die Entkopplungsdioden erfordern zwei Lötpunkte je Tastenschalter.

Es sind ferner sogenannte Folien-oder Gummimattenkontaktfelder bekannt, die in einem matrixförmigen Raster, häufig
entsprechend der Anordnung der Tasten im Tastenfeld zeilenweise gegeneinander versetzt, elastisch verformbare,
blasenartige  Erhebungen besitzen. Auf der Unterseite der
Erhebungen sind Kontaktplättchen befestigt, die zwei benachbarte, jeweils mit einer Zeilenleitung und einer
Spaltenleitung verbundene Kontaktflecken auf der Verdrahtungsplatte kurzschließen, wenn eine der über den Erhebungen stehenden Tasten gedrückt wird.

She 1 Pe/3.06.83

0131185
85 - 1441 E

Mit Hilfe der beschriebenen Kontaktausbildungen wäre es an sich möglich, lötfreie Tastenfelder zu schaffen, wenn nicht der Einbau der Entkopplungsdioden Lötungen erforderlich machen würde.

Es ist daher die Aufgabe der Erfindung, eine Möglichkeit für die Anordnung von Entkopplungsdioden aufzuzeigen, die keine Lötvorgänge in der Verdrahtungsplatte eines Tastenfelds notwendig macht. Gemäß der Erfindung wird diese Aufgabe dadurch gelöst, daß die Entkopplungsdioden in die beweglichen Teile der Schaltkontakte der Tastenschalter integriert sind.

Im folgenden wird die Erfindung anhand von Ausführungsbeispielen, die in der Zeichnung dargestellt sind, näher erläutert. Es zeigt darin:

Fig.1 einen Schnitt durch einen Gummimattenkontakt,

Fig.2 und 3 weitere Bespiele für die Ausbildung der beweglichen Teile (Kontaktbrücken) der Tastenschalter mit integrierter Entkopplungsdiode.

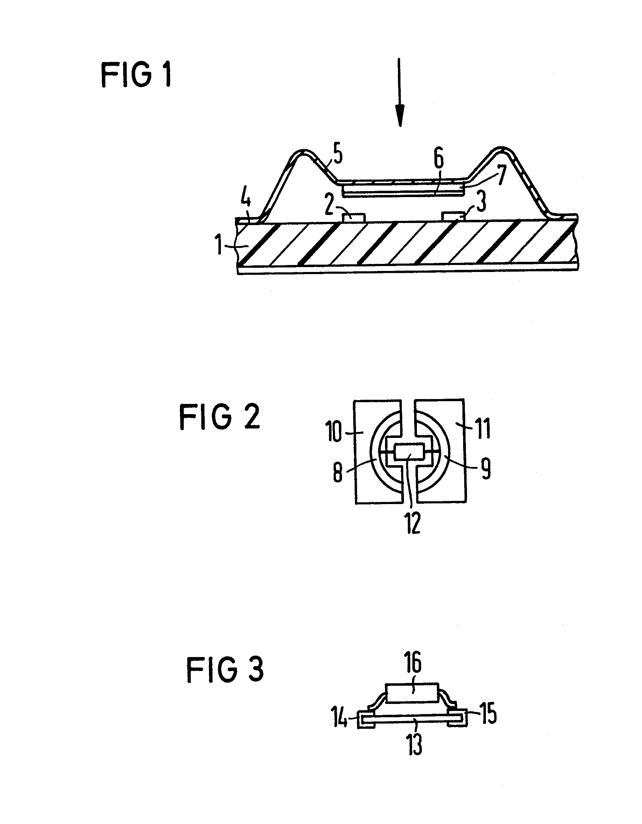

Die Figur 1 zeigt schematisch einen Abschnitt einer Verdrahtungsplatte 1 eines Tastenfeldes. Ein Kontaktfleck 2 ist mit einer Zeilenleitung und ein Kontaktfleck 3 mit einer Spaltenleitung eines matrixförmigen Verdrahtungsfeldes verbunden. Eine Gummimatte oder Folie 4 liegt im wesentlichen auf der Verdrahtungsplatte 1 auf. An jeder Kontaktierungsstelle besitzt die Gummimatte 4 eine Erhebung 5, wie aus Figur 1 ersichtlich ist. Bei einer bekannten Ausführung sind auf der Unterseite solcher Erhebungen 5 bewegliche Kontaktbrücken 6 in Form von Metall- oder Kohleplättchen entsprechender Größe befestigt, die jeweils zwei Kontaktflecken 2 und 3 miteinander elektrisch verbinden, wenn eine Erhebung 5 in Richtung des nicht bezeichneten Pfeils bis zum Anschlag niedergedrückt wird. Das geschieht beispielsweise mit Hilfe einer über der Erhebung 5 stehenden, nicht dargestellten Taste.

Gemäß der Erfindung ist eine solche Kontaktbrücke 6 jedoch nicht homogen, sondern besteht beispielsweise aus einem Hybridplättchen, das an seinen beiden Enden Kontaktflächen aufweist, die den Kontaktflecken 2 und 3 gegenüberstehen. Zwischen den Kontaktflächen befindet sich eine Halbleiterdiode, deren Anschlüsse mit den Kontaktflächen verbunden sind. Beim Niederdrücken einer Taste wird somit eine Verbindung zwischen einer Zeilenleitung und einer Spaltenleitung über eine Entkopplungsdiode hergestellt. Zur Verminderung der Bruchgefahr wird das Hybridplättchen 6 vorzugsweise auf einem isolierenden Trägerplättchen 7 befestigt.

Die Kontaktbrücke 6 kann auch aus einem Siliziumplättchen bestehen, das zweckmäßig auf einem Träger ausreichender Festigkeit aufliegt. Im mittleren Bereich des Siliziumplättchens ist eine Diode ausgebildet, die Oberflächen der äußeren Bereiche sind metallisiert oder tragen eine Schicht Polysilizium.

Gemäß einer weiteren Ausführungsform der Kontaktbrücke 6 sind zwei flache kubische Körper aus leitendem Material vorgesehen, deren Grundflächen die Kontaktflächen bilden. Zwischen den einander gegenüberstehenden Stirnflächen der Körper befindet sich die Entkopplungsdiode, wobei die p-dotierte Halbleiterschicht an die Stirnfläche des einen Körpers und die n-dotierte Halbleiterschicht an die Stirnfläche des anderen Körpers angrenzt. Die ganze Anordnung ist aus Gründen der Festigkeit vorzugsweise wieder auf eine Trägerplatte aufgeklebt.

Eine andere Möglichkeit zur Ausbildung einer Kontaktbrücke 6 gemäß der Erfindung besteht nach Figur 2 in der Anordnung von zwei annähernd halbkreisförmigen Kontaktflächen 8 und 9 auf Distanzstücken 10 und 11. Zwischen den beiden Kontaktflecken ist eine als Einzelbauelement handelsübliche Diode 12 in Miniaturbauweise mit axialen Anschlußdrähten angeschlossen.

Bei einer Kontaktbrücke gemäß Figur 3 werden zwei einander gegenüberliegende Kanten eines isolierenden Trägers 13 von U-förmigen Kontaktschienen 14 und 15 umfaßt. Die unteren Schenkel der Kontaktschienen 14 und 15 entsprechen den Kontaktflächen der Kontaktbrücke nach Figur 1. Mit den oberen Schenkeln sind die Anschlußpins einer Diode 16 in einer für Schichtschaltungen vorgesehenen Bauweise verbunden.

Es ist ferner möglich, bei Dioden mit axialen Anschlußdrähten die Anschlußdrähte breit zu quetschen und mittels Distanzstücken auf der Unterseite einer Erhebung 5 der Gummimatte oder Folie 4 zu befestigen. Die gequetschten Anschlußdrähte bilden die Gegenkontakte zu den Kontaktflecken 2 und 3.

Weiter können an die Anschlußdrähte von Dioden kleine Metallplättchen oder kurze, senkrecht zu den Anschlußdrähten stehende Drahtstückchen angeschweißt und diese als Gegenkontakte verwendet werden.

3 Figuren
7 Patentansprüche

## Patentansprüche

*beweglichen*

1. Tastenschalter mit als Kontaktbrücke ausgebildeten Schaltkontakten zur zeitweiligen galvanischen Verbindung einer Zeilenleitung und einer Spaltenleitung an einem Kreuzungspunkt solcher Leitungen in einem Tastenfeld mit einer Vielzahl von sich kreuzenden Zeilen-und Spaltenleitungen auf einer Verdrahtungsplatte, mit in Serie zu den Schaltkontakten angeordneten Entkopplungsdioden, d a d u r c h  g e k e n n z e i c h n e t, daß die Entkopplungsdioden (12,16) in die Kontaktbrücken (6) integriert sind.

2. Tastenschalter nach Anspruch 1, d a d u r c h  g e - k e n n z e i c h n e t, daß die Kontaktbrücken (6) jeweils zwei Kontaktflächen (8,9,14,15) aufweisen, die auf der Verdrahtungsplatte (1) angeordneten, mit einer Zeilenleitung und einer Spaltenleitung verbundenen Kontaktflecken (2,3) gegenüberstehen und daß die Kontaktflächen (8,9, 14,15) über Dioden (12,16) verbunden sind.

3. Tastenschalter nach Anspruch 2, d a d u r c h  g e - k e n n z e i c h n e t, daß die Kontaktbrücke (6) als monolytisch integrierte Schaltungsanordnung ausgebildet und auf einer isolierenden Trägerplatte (7) befestigt ist.

4. Tastenschalter nach Anspruch 2, d a d u r c h  g e - k e n n z e i c h n e t, daß die Kontaktflächen der Kontaktbrücke (6) durch je eine Grundfläche von zwei flachen kubischen Körpern aus leitendem Material gebildet werden, zwischen denen eine gehäuselose Diode angeordnet ist, wobei die Stirnflächen der Körper als Elektroden dienen.

5. Tastenschalter nach Anspruch 2, d a d u r c h   g e -
k e n n z e i c h n e t, daß die Kontaktbrücke (6) zwei
annähernd halbkreisförmige, auf Distanzstücken (10,11)
angeordnete Kontaktflächen (8,9) aufweist, die durch eine
Diode (12) mit axialen Anschlußdrähten verbunden sind.

6. Tastenschalter nach Anspruch 2, d a d u r c h   g e -
k e n n z e i c h n e t, daß die Kontaktbrücke (6) eine
Isolierstoffplatte (13) enthält, bei der zwei gegenüberliegende Kanten von U-förmigen Kontaktschienen (14,15)
umfaßt sind, daß die jeweils unteren Schenkel der Kontaktschienen (14,15) die Kontaktflächen bilden und daß mit
den jeweils oberen Schenkeln die Anschlußpins einer für
den Einsatz in  Schichtschaltungen geeigneten Diode (16)
verbunden sind.

7. Tastenschalter nach Anspruch 2, d a d u r c h   g e -
k e n n z e i c h n e t, daß an die Anschlußdrähte
einer Diode mit axialen Anschlußdrähten zwei als Kontaktflächen dienende Metallplättchen angeschweißt sind.

1/1

FIG 1

FIG 2

FIG 3